# EUROPEAN PATENT SPECIFICATION

(11) **EP 2 754 212 B1**
(45) Date of publication and mention of the grant of the patent: **16.05.2018**
(21) Application number: 12773353.3
(22) Date of filing: 07.09.2012
(51) Int. Cl.: H01R 13/66, H01R 13/703, H01R 24/58, H01R 13/717

(54) **ELECTRICAL SOCKET**
ELEKTRISCHE STECKERBUCHSE
DOUILLE ÉLECTRIQUE

(30) Priority: 09.09.2011 GB 201115628
(43) Date of publication of application: 16.07.2014
(73) Proprietor: IFPL Group Limited, Isle of Wight PO30 4JY (GB)
(72) Inventor: UNDERWOOD, Geoffrey Paul, Newport Isle of Wight PO30 4JY (GB)
(74) Representative: Barker Brettell LLP
(86) International application number: PCT/GB2012/052213
(87) International publication number: WO 2013/034929

(56) References cited:
- WO-A1-2009/077004
- US-A1- 2007 001 866
- US-A1- 2008 298 607
- US-A1- 2008 305 676
- US-A1- 2008 305 676
- US-A1- 2010 215 183
- US-A1- 2011 099 298
- US-B1- 7 209 048
- US-B1- 7 579 832

## Description

### Technical field

The present invention relates generally to electrical sockets.

### Background

It is known for passenger aircraft to include 'at-seat' passenger entertainment systems, with a passenger entertainment station being provided for each passenger, installed in or adjacent to each passenger's seat. Such systems allow passengers to insert a plug of a headphone set (or indeed other sound reproduction equipment) into an audio socket of the station and then listen to audio content provided by the system. Such systems typically allow each passenger to select one of a number of channels, for example including music or the spoken word, in conjunction with, or independently of, displayed visual content. During changeover periods between passengers leaving the aircraft and prior to new passengers boarding the aircraft, aircraft crew need to ensure that each passenger entertainment station is functioning correctly (prior to arrival of the new passengers). This check may include inserting the plug of a headphone set into the socket, or jack, of each station and verifying that there is audible content. We have realised that this procedure could be made more efficient by providing an improved passenger entertainment system.

WO 2009/077004 relates to a device which connects to a personal media playback product which detects when there is an incoming call to a user's mobile phone, and interrupts media playing, to signal the incoming call to the user.

### Summary

According to a first aspect of the invention there is provided an audio interface comprising a socket arranged to receive a plug, the socket arranged to transfer an audio signal to the plug when connected to the socket, the interface comprising a detector to determine whether an audio signal is received at the socket, the detector arranged to cause generation of a test signal to indicate that an audio signal is received at the socket, at least when the plug is not inserted in the socket.

The detector may be arranged to cause the test signal to be generated only when the plug is not connected to the socket. Preferably, the detector causes discontinuation of generation of the test signal when, and during, it is determined that the plug is connected to the socket.

The detector may comprise a switch which controls generation of the test signal, based on whether the switch is open or closed. The detector may be arranged to deactivate a test signal generator when it is determined that the plug is connected to the socket.

The detector may be arranged to cause the test signal to be generated when it is determined that an audio signal is received at an electrical terminal of the socket. The detector may be arranged to cause generation of the test signal when it is determined that an audio signal is received at both or all of the electrical terminals of the socket.

The test signal may be arranged to be received locally or remotely of the interface. The test signal generated may comprise a visual indication. The visual indication may be provided by a light generating component. The light-generating component may be provided as part of the interface, and may be provided adjacent to the socket.

The test signal may be generated using (electrical) power sourced from the audio signal. The detector may be such as to direct the audio signal towards a test signal generator when the plug is not connected to the socket.

The interface may comprise a resilient element which is arranged to engage with a pin of the plug such that on connection of the plug to the interface the resilient element serves as a switch to direct audio signal away from generating a test signal to be directed to an output of the plug, and when the plug is not connected to the interface, the resilient element directs the audio signal towards a test signal generator. The resilient element is preferably an electrical terminal arranged to carry an audio signal and preferably selectively transfer the signal to the plug or to the test signal generator.

Alternatively, instead of the test signal being generated from power of the audio signal, the signal may be generated from a separate power supply, and wherein the detector causes a test signal generator to be selectively connected to the power supply dependent on whether the plug is connected to the socket.

The detector preferably serves to determine whether the plug is connected to or disconnected from the socket.

The detector may be an active or passive component.

The interface may be a passenger audio interface for an aircraft, or other passenger transportation. Moreover, the audio interface may be used in any application in which many audio interfaces are provided, which, in addition to passenger transportation (such as planes, trains, coaches, buses and mass transportation), includes venues such as stadia, theatres, conference centres, classrooms etc.

According to a second aspect of the invention there is provided a test system for a plurality of audio interfaces, the system comprising a plurality of audio interfaces of the first aspect, and an output device to information derived from received test signals from the audio interfaces.

### Brief description of the drawings

Various embodiments of the invention will now be described, by way of example only, with reference to the following drawings in which:
**Figure 1** is a schematic perspective view of an audio interface,
**Figure 2** is a side view of a plug which is insertable into the socket of the interface of Figure 1,
**Figure 3** is a block diagram of a test signal circuit of the audio interface of Figure 1,

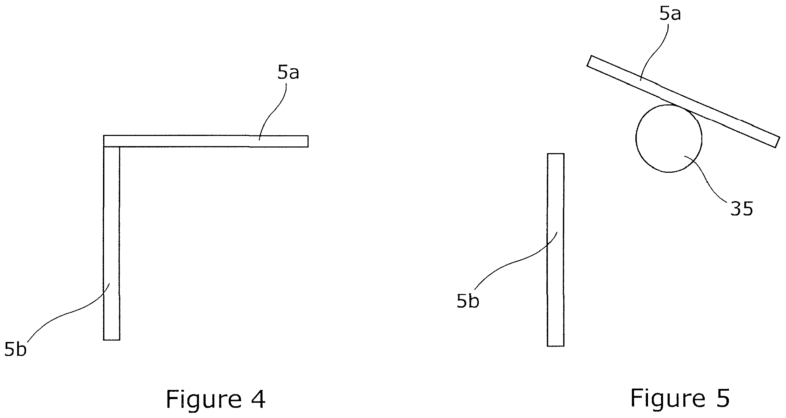

**Figure 4** is a schematic view of terminals of the interface in a closed condition, and
**Figure 5** is a schematic view of terminals of the interface with the plug inserted in an open condition.

### Detailed description

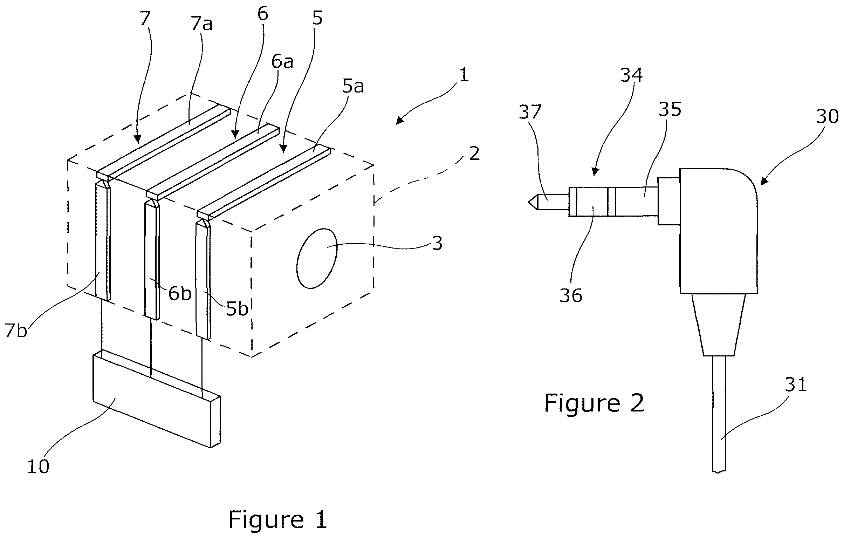

Reference is made initially to Figure 1 which shows an audio interface 1 for use in an aircraft, which allows a passenger to connect headphones to the interface and so allow the passenger to listen to the on-board entertainment system. The interface 1 is usually provided at or adjacent to each passenger's seat. As will be described in more detail below, the interface allows crew of the aircraft to check that audio is received at the interface and so ensure correct operation of the interface.

The interface 1 comprises an opening 3, which allows a plug 30, which is connected to an audio headset or earphones by way of a cable 31, to be inserted into the socket 2 of the interface by the passenger. Within the socket, there are provided three pairs of electrical terminals 5, 6 and 7. Each terminal comprises two parts, a fixed terminal and a sprung, or resiliently deflectable, terminal. Specifically, the terminal pair 5 comprises a sprung terminal 5a and a fixed terminal 5b, the terminal pair 6 comprises a sprung terminal 6a and a fixed terminal 6b, and, the terminal pair 7 comprises a sprung terminal 7a and 7a fixed terminal 7b. Each of the sprung terminals is connected to the audio signal of the aircraft's inflight entertainment system by way of electrical wiring (not shown). Each of the terminals is spaced along the depth of the socket so that each terminal corresponds to the longitudinal position of a contact portion 35, 36 and 37 respectively of the pin 34 of plug 30, such that each portion contacts with a respective sprung terminal so that the audio signal is connected to the passenger's audio equipment. The terminal pair 5 is connected to a left channel audio signal, the terminal pair 6 is connected to a right audio channel and the terminal pair 7 is connected to ground.

The interface 1 further comprises a test signal circuit 10. The test signal circuit 10 comprises, for each of the left channel signal and the right channel signal, a voltage amplifier 45 and 46, a rectifier 55 and 56, logic circuitry 60, and a light-emitting diode 70.

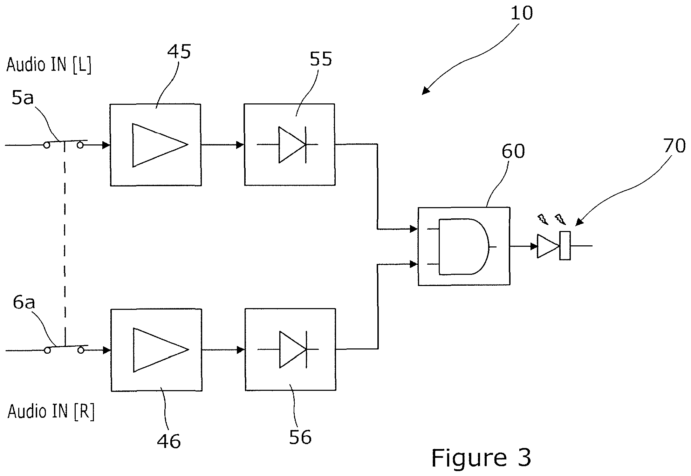

In the condition in which the plug is not inserted into socket 2, the distal end of each of the sprung terminals electrically contacts the distal ends of the respective fixed terminals, as shown in Figure 1. In this condition, the left, right and ground signals are connected to the test signal circuit 10, via the fixed terminals. With reference to Figure 3 it can be seen that each of the left and right channel signals is first amplified and then rectified prior to serving as inputs for the AND gate of the logic circuitry at 60. If both left and right channels are present then the AND gate will output HIGH. This HIGH output then serves to power the LED 70. This condition, in which the LED is illuminated, is indicative of the fact that an audio signal is present at both of left and right channel terminals. Moreover, this condition is indicative of the fact that there is continuity through each of the terminals. Conveniently, the LED is arranged to radiate visible light externally of the interface so aircraft personnel can easy check whether the LED for each seat is illuminated. If it is not illuminated, then this means that one or both of the left or right audio signals is not received at the terminals of the interface, and so the fault needs to be investigated and rectified as necessary. The LED may be provided at or adjacent to the interface 1, or close to each passenger seat, so that the staff can easily identify with which seat any faulty audio interface is associated. Hitherto, this procedure of check that the audio interface of each seat was operating correctly was performed by the staff manually inserting a plug of a headset into each interface, and then manually verifying that audio could be heard. This is clearly a lengthy and laborious procedure (given that a few hundred interfaces may need to be checked as operating correctly). Such a procedure would usually be conducted in the time between when passengers have left the aircraft and prior to new passengers boarding the aircraft. During such changeover periods time is short, since other duties in making the aircraft ready for the new passengers need to performed.

It should be appreciated that when the plug 30 is inserted into the socket 2, the pin 34 engages with the sprung terminals so as to deflect them away from electrical connection with the fixed terminals and into electrical connection with the respective portions of the pin. With the plug so inserted, the audio signals are routed/diverted away from the test circuit 10 and towards the audio headset. In this condition, the LED is not powered and remains extinguished for as long as the plug is inserted. With the plug removed, the resilience of the sprung terminals returns them to being in contact with the fixed terminals.

In the above embodiment, we use the audio content generated by the entertainment system that would be heard by passengers, for the purpose of powering generation of the test signal. However, in an alternative embodiment, for the purpose of the test procedure, we substitute the audio content that would usually be directed to the interfaces for passenger entertainment, for a dedicated source test signal, used solely for the purpose of checking the operability of each of the interfaces. Such a source test signal would be transmitted to each interface in place of the usual audio content. The frequency of transmission of the source test signal may be around 15 kHz. Once the test procedure has been completed, the source test signal is discontinued and transmission of the usual audio content is then re-commenced to the interfaces.

Advantageously, in the above embodiments, no additional power supply is required, since the LED is powered from an amplified and rectified audio signal.

In an alternative embodiment, the test signal may not be displayed at or next to each seat or interface, but rather may be provided remote from the interface, for example, the output of each test circuit could be fed to a (master) monitoring station, whereby staff could immediately identify from an output given by the monitoring station any interfaces of any seats for the entire aircraft which the 'operative' test signal was not received. The combination of the monitoring station and the audio interfaces may be viewed as forming a testing system. It may be that a signal/data processor could be provided in such a system so as to determine from which interfaces an 'operative' test signal is not received, and then to display to staff at the monitoring station the identity of that/those interfaces which are determined to be faulty.

In a further alternative embodiment, instead of an audio signal being used to power a test signal, another power source may be used (ie other than the audio signal), such as for example that to a passenger equipment power supply socket. In such an embodiment, when the plug is not inserted into the socket, a switch is closed, so as to cause a test signal (powered from the power source) to be generated. However, when a plug is inserted, the switch is caused to opened, and the power source disconnected from a test signal generator.

In yet further embodiments, the test signal may be arranged to be generated even when a plug is connected to the interface.

Advantageously, the above embodiments form what may be viewed as a self-testing jack, saving considerable time and effort verifying the operability of a multitude of audio interfaces. Further advantageously, when the test signal is generated from power derived from an audio signal, (with for example, the electrical power received at the interface representative of music or audio content which is used to power the test circuit), or at least serve as a power source for generation of the test signal, this obviates the need for any additional power supply for generation of the test signal.

## Claims

1. An audio interface (1) comprising a socket (3) arranged to receive a plug (30), the socket arranged to transfer an audio signal to the plug when connected to the socket, the interface comprising a detector (10) to determine whether an audio signal is received at the socket, the detector arranged to cause generation of a test signal to indicate that an audio signal is received at the socket, at least when the plug is not inserted in the socket.

2. An audio interface as claimed in claim 1 in which the detector (10) is arranged to cause the test signal to be generated only when the plug (30) is not connected to the socket (3).

3. An audio interface as claimed in claim 1 or claim 2 in which the detector (10) causes discontinuation of generation of the test signal when, and during, it is determined that the plug (30) is connected to the socket (3).

4. An audio interface as claimed in any preceding claim in which the detector (10) comprises a switch (5a; 6a) which controls generation of the test signal, based on whether the switch is open or closed.

5. An audio interface as claimed in any preceding claim in which the detector (10) is arranged to deactivate a test signal generator when it is determined that the plug is connected to the socket (3).

6. An audio interface as claimed in any preceding claim in which the detector (10) is arranged to cause the test signal to be generated when it is determined that an audio signal is received at an electrical terminal of the socket (3).

7. An audio interface as claimed in any preceding claim in which the detector (10) is arranged to cause generation of the test signal when it is determined that an audio signal is received at both or all of the electrical terminals of the socket (3).

8. An audio interface as claimed in any preceding claim in which the test signal generated comprises a visual indication.

9. An audio interface as claim in claim 8 in which the light-generating component is provided as part of the interface (1).

10. An audio interface as claim in any preceding claim in which the test signal is generated using power sourced from the audio signal.

11. An audio interface as claimed in any preceding claim in which the detector (10) is such as to direct the audio signal towards a test signal generator when the plug (30) is not connected to the socket (30).

12. An audio interface (1) as claimed in any preceding claim which comprises a resilient element (5a; 6a) which is arranged to engage with a pin (34) of the plug (30) such that on connection of the plug to the interface the resilient element serves as a switch to direct audio signal away from generating a test signal to be directed to an output of the plug, and when the plug is not connected to the interface, the resilient element directs the audio signal towards a test signal generator.

13. An audio interface as claimed in claim 12 in which the resilient element (5a; 6a) is an electrical terminal arranged to carry an audio signal and preferably selectively transfer the signal to the plug (30) or to the test signal generator.

14. An audio interface as claimed in any preceding claim in which the detector (10) serves to determine whether the plug (30) is connected to or disconnected from the socket (3).

15. A test system for a plurality of audio interfaces, the system comprising a plurality of audio interfaces (1) as claimed in any of claims 1 to 14 and an output device to information derived from received test signals from the audio interfaces.

## Patentansprüche

1. Audioschnittstelle (1), die eine Buchse (3) umfasst, die dafür ausgelegt ist, einen Stecker (30) aufzunehmen, wobei die Buchse dafür ausgelegt ist, ein Audiosignal an den Stecker zu übertragen, wenn dieser mit der Buchse verbunden ist, wobei die Schnittstelle einen Detektor (10) aufweist, um zu bestimmen, ob bei der Buchse ein Audiosignal empfangen wird, wobei der Detektor dafür ausgelegt ist, wenigstens dann, wenn der Stecker nicht in die Buchse eingesteckt ist, die Erzeugung eines Prüfsignals zu veranlassen, um anzugeben, dass an der Buchse ein Audiosignal empfangen wird.

2. Audioschnittstelle nach Anspruch 1, wobei der Detektor (10) dafür ausgelegt ist, das Erzeugen des Prüfsignals nur dann zu veranlassen, wenn der Stecker (30) nicht mit der Buchse (3) verbunden ist.

3. Audioschnittstelle nach Anspruch 1 oder Anspruch 2, wobei der Detektor (10) eine Unterbrechung der Erzeugung des Prüfsignals veranlasst, wenn und während bestimmt wird, dass der Stecker (30) mit der Buchse (3) verbunden ist.

4. Audioschnittstelle nach einem vorhergehenden Anspruch, wobei der Detektor (10) einen Schalter (5a; 6a) umfasst, der die Erzeugung des Prüfsignals in Abhängigkeit davon steuert, ob der Schalter geöffnet oder geschlossen ist.

5. Audioschnittstelle nach einem vorhergehenden Anspruch, wobei der Detektor (10) dafür ausgelegt ist, einen Prüfsignalgenerator zu deaktivieren, wenn bestimmt wird, dass der Stecker mit der Buchse (3) verbunden ist.

6. Audioschnittstelle nach einem vorhergehenden Anspruch, wobei der Detektor (10) dafür ausgelegt ist, die Erzeugung des Prüfsignals zu veranlassen, wenn bestimmt wird, dass an einem elektrischen Anschluss der Buchse (3) ein Audiosignal empfangen wird.

7. Audioschnittstelle nach einem vorhergehenden Anspruch, wobei der Detektor (10) dafür ausgelegt ist, die Erzeugung des Testsignals zu veranlassen, wenn bestimmt wird, dass an beiden oder allen elektrischen Anschlüssen der Buchse (3) ein Audiosignal empfangen wird.

8. Audioschnittstelle nach einem vorhergehenden Anspruch, wobei das erzeugte Prüfsignal eine visuelle Angabe enthält.

9. Audioschnittstelle nach Anspruch 8, wobei die lichterzeugende Komponente als Teil der Schnittstelle (1) vorgesehen ist.

10. Audioschnittstelle nach einem vorhergehenden Anspruch, wobei das Prüfsignal unter Verwendung von Leistung, die dem Audiosignal entnommen wird, erzeugt wird.

11. Audioschnittstelle nach einem vorhergehenden Anspruch, wobei der Detektor (10) so beschaffen ist, dass er das Audiosignal zu einem Prüfsignalgenerator leitet, wenn der Stecker (30) nicht mit der Buchse (30) verbunden ist.

12. Audioschnittstelle (1) nach einem vorhergehenden Anspruch, die ein elastisches Element (5a, 6a) umfasst, das dafür ausgelegt ist, mit einem Stift (34) des Steckers (30) in Eingriff zu gelangen, so dass bei einer Verbindung des Steckers mit der Schnittstelle das elastische Element als ein Schalter dient, um das Audiosignal davon abzuhalten, ein zu einem Ausgang des Steckers zu leitendes Prüfsignal zu erzeugen, während dann, wenn der Stecker nicht mit der Schnittstelle verbunden ist, das elastische Element das Audiosignal zu einem Prüfsignalgenerator leitet.

13. Audioschnittstelle nach Anspruch 12, wobei das elastische Element (5a; 6a) ein elektrischer Anschluss ist, der dafür ausgelegt ist, ein Audiosignal zu führen und vorzugsweise das Signal wahlweise an den Stecker (30) oder an den Prüfsignalgenerator zu übertragen.

14. Audioschnittstelle nach einem vorhergehenden Anspruch, wobei der Detektor (10) dazu dient, zu bestimmen, ob der Stecker (30) mit der Buchse (3) verbunden oder von ihr getrennt ist.

15. Prüfsystem für mehrere Audioschnittstellen, wobei das System mehrere Audioschnittstellen (1) nach einem der Ansprüche 1 bis 14 und eine Ausgabevorrichtung für Informationen, die von empfangenen Prüfsignalen von den Audioschnittstellen abgeleitet werden, umfasst.

## Revendications

1. Interface audio (1) comprenant une prise femelle (3) agencée pour recevoir une prise mâle (30), la prise femelle étant agencée pour transférer un signal audio à la prise mâle lorsqu'elle est branchée à la prise femelle, l'interface comprenant un détecteur (10) pour déterminer si un signal audio est reçu au niveau de la prise femelle, le détecteur étant agencé pour provoquer la génération d'un signal d'essai pour indiquer qu'un signal audio est reçu au niveau de la prise femelle, au moins lorsque la prise mâle n'est pas insérée dans la prise femelle.

2. Interface audio selon la revendication 1, dans laquelle le détecteur (10) est agencé pour provoquer la génération du signal d'essai uniquement lorsque la prise mâle (30) n'est pas branchée à la prise femelle (3).

3. Interface audio selon la revendication 1 ou la revendication 2, dans laquelle le détecteur (10) provoque une interruption de génération du signal d'essai lorsque, et pendant que l'on détermine que la prise mâle (30) est branchée à la prise femelle (3).

4. Interface audio selon l'une quelconque des revendications précédentes, dans laquelle le détecteur (10) comprend un interrupteur (5a ; 6a) qui commande la génération du signal d'essai, selon que l'interrupteur est ouvert ou fermé.

5. Interface audio selon l'une quelconque des revendications précédentes, dans laquelle le détecteur (10) est agencé pour désactiver un générateur de signal d'essai lorsque l'on détermine que la prise mâle est branchée à la prise femelle (3).

6. Interface audio selon l'une quelconque des revendications précédentes, dans laquelle le détecteur (10) est agencé pour provoquer la génération du signal d'essai lorsque l'on détermine qu'un signal audio est reçu au niveau d'une borne électrique de la prise femelle (3).

7. Interface audio selon l'une quelconque des revendications précédentes, dans laquelle le détecteur (10) est agencé pour provoquer la génération du signal d'essai lorsque l'on détermine qu'un signal audio est reçu au niveau des deux ou de toutes les bornes électriques de la prise femelle (3).

8. Interface audio selon l'une quelconque des revendications précédentes, dans laquelle le signal d'essai généré comprend une indication visuelle.

9. Interface audio selon la revendication 8, dans laquelle le composant de génération de lumière est prévu dans le cadre de l'interface (1).

10. Interface audio selon l'une quelconque des revendications précédentes, dans laquelle le signal d'essai est généré à l'aide d'une alimentation issue du signal audio.

11. Interface audio selon l'une quelconque des revendications précédentes, dans laquelle le détecteur (10) est de nature à diriger le signal audio vers un générateur de signal d'essai lorsque la prise mâle (30) n'est pas branchée à la prise femelle (30).

12. Interface audio (1) selon l'une quelconque des revendications précédentes, qui comprend un élément résilient (5a ; 6a) qui est agencé pour s'enclencher avec une broche (34) de la prise mâle (30) de sorte que lors du branchement de la prise mâle à l'interface, l'élément résilient serve d'interrupteur pour éloigner le signal audio de la génération d'un signal d'essai à diriger vers une sortie de la prise mâle, et lorsque la prise mâle n'est pas branchée à l'interface, l'élément résilient dirige le signal audio vers un générateur de signal d'essai.

13. Interface audio selon la revendication 12, dans laquelle l'élément résilient (5a ; 6a) est une borne électrique agencée pour acheminer un signal audio et de préférence transférer sélectivement le signal à la prise mâle (30) ou au générateur de signal d'essai.

14. Interface audio selon l'une quelconque des revendications précédentes, dans laquelle le détecteur (10) sert à déterminer si la prise mâle (30) est branchée à ou débranchée de la prise femelle (3).

15. Système d'essai pour une pluralité d'interfaces audio, le système comprenant une pluralité d'interfaces audio (1) telles que revendiquées à l'une quelconque des revendications 1 à 14 et un dispositif de sortie pour des informations dérivées de signaux d'essai reçus en provenance des interfaces audio.
